# EUROPEAN PATENT APPLICATION

(11) **EP 4 016 625 A1**
(43) Date of publication of application: **22.06.2022**
(21) Application number: 21194830.2
(22) Date of filing: 03.09.2021
(51) Int. Cl.: H01L 27/11514

(54) **PLATE LINE ARCHITECTURES FOR 3D-FERROELECTRIC RANDOM ACCESS MEMORY (3D-FRAM)**

(30) Priority: 21.12.2020 US 202017129851
(71) Applicant: INTEL Corporation, Santa Clara, CA 95054 (US)
(72) Inventor: Shivaraman, Shriram, Hillsboro, 97124 (US); AVCI, Uygar E., Portland, 97225 (US); Chang, Sou-Chi, Portland, 97229 (US); HARATIPOUR, Nazila, Hillsboro, 97124 (US); KAVALIEROS, Jack, Portland, 97229 (US)
(74) Representative: Goddar, Heinz J.

(57) **Abstract**

Plate line architectures for 3D-Ferroelectric Random Access Memory (3D-FRAM) are described. In an example, a memory device includes a plurality of bitlines (108) along a first direction and a plurality of wordlines (110) along a second direction orthogonal to the first direction. An access transistor (106) is at an intersection of a first one of the bitlines and a first one of the wordlines. A series of alternating plate lines (PL1, ..., PL4) and insulating material (118) are fabricated over the access transistor. Two or more ferroelectric capacitors (102) are over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor.

## Description

### TECHNICAL FIELD

Embodiments of the disclosure are in the field of integrated circuit structures and, in particular, a 3D-Ferroelectric Random Access Memory (3D-FRAM).

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and state-of-the-art fabrication processes may limit the possibility to further extend them into the sub-10 nm range. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1A illustrates a cross-section of a 3D FRAM memory, in accordance with an embodiment of the present disclosure.
Figure 1B illustrates a top view of the 3D FRAM memory, in accordance with an embodiment of the present disclosure.
Figure 1C illustrates a cross-section of the 3D FRAM memory along cross-section line A, in accordance with an embodiment of the present disclosure.
Figure 2A illustrates a cross-section of a 3D FRAM memory, in accordance with a second embodiment of the present disclosure.
Figure 2B illustrates a circuit diagram showing a portion of a 3D FRAM memory array, in accordance with an embodiment of the present disclosure.
Figure 3A illustrates a top down view of a plate line having a single plate per tier, in accordance with an embodiment of the present disclosure.
Figure 3B is a schematic showing part of a memory sub-array having a plate line architecture of the type of Figure 3A, in accordance with an embodiment of the present disclosure.
Figure 3C illustrates a top down view of plate lines having multiple plate lines per tier oriented along a bitline direction, in accordance with an embodiment of the present disclosure.
Figure 3D is a schematic showing part of a memory sub-array having a plate line architecture of the type of Figure 3C, in accordance with an embodiment of the present disclosure.
Figure 3E illustrates a top down view of plate lines having multiple plates per tier oriented along a wordline direction, in accordance with an embodiment of the present disclosure.
Figure 3F is a schematic showing part of a memory sub-array having a plate line architecture of the type of Figure 3E, in accordance with an embodiment of the present disclosure.
Figure 4A illustrates one possible operation table showing programming of bit cells along wordline WL1 and plate line PL1, in accordance with an embodiment of the present disclosure.
Figure 4B illustrates one possible operation table with example values for the voltages applied to program and erase a bit cell, in accordance with an embodiment of the present disclosure.
Figures 5A-5G illustrate cross-sectional views showing a process for fabricating a 3D FRAM in further detail, in accordance with an embodiment of the present disclosure.
Figures 6A and 6B are top views of a wafer and dies that include one or more 3D-FRAM, in accordance with one or more of the embodiments disclosed herein.
Figure 7 illustrates a block diagram of an electronic system, in accordance with an embodiment of the present disclosure.
Figure 8 is a cross-sectional side view of an integrated circuit (IC) device assembly that may include one or more ferroelectric trench capacitors, in accordance with one or more of the embodiments disclosed herein.
Figure 9 illustrates a computing device in accordance with one implementation of the disclosure.

### DESCRIPTION OF THE EMBODIMENTS

A 3D-Ferroelectric Random Access Memory (3D-FRAM) is described. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features, such as single or dual damascene processing, are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments may be implemented to realize a 3D ferroelectric RAM (FRAM, FeRAM, or F-RAM) to potentially increase monolithic integration of backend logic plus memory in SoCs of future technology nodes. To provide context, a FRAM is a random-access memory similar in construction to DRAM but uses a ferroelectric layer instead of a dielectric layer to achieve non-volatility. Conventionally, both FRAM and DRAM are one transistor (1T)/one capacitor (1C) cell arrays, where each cell includes an access transistor in the front end coupled to a single capacitor. The capacitor may be coupled to a bitline (COB) higher in the stack in the semiconductor back end. Both FRAM and DRAM memories include 1 bit per access transistor, and the access transistor occupies valuable silicon real estate of the wafer. Consequently, the cells are relatively large in size. For example, a 1T-1C DRAM cell may have an area 8F² (F: min. feat. size).

One or more embodiments described herein are directed to structures and architectures for fabricating a 3D-FRAM in which multiple ferroelectric capacitors are connected to a single access device to provide multiple bits per transistor. One or more embodiments may be directed to a vertical ferroelectric memory device including a bitline along a first direction. A wordline is along a second direction orthogonal to the first direction. An access transistor is coupled to the bitline and the wordline. A first ferroelectric capacitor is vertically aligned with and coupled to the access transistor. A second ferroelectric capacitor is vertically aligned with the first ferroelectric capacitor and coupled to the access transistor, wherein both the first ferroelectric capacitor and the second ferroelectric capacitor are controlled by the access transistor. Along similar lines, more capacitors may be stacked on top of the access device. One or more embodiments described herein are directed to plate line architectures for 3D-FRAM

A 3D-FRAM having multiple bits per access transistor results in a FRAM can have a high bit-density of 5-10 times greater than traditional FRAM and DRAM memories with low cost and area per bit. Embodiments may include or pertain to one or more of memory, ferroelectric memory, 3D ferroelectric memory and system-on-chip (SoC) technologies.

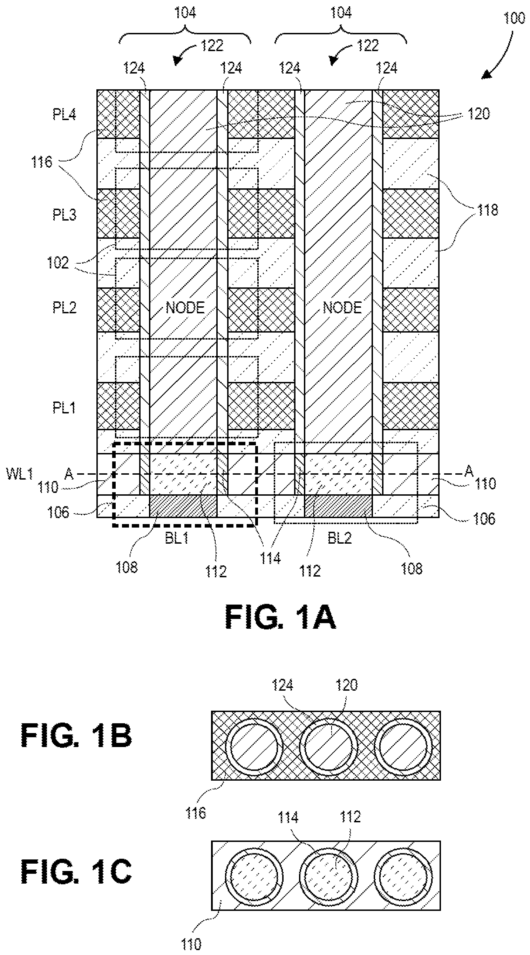

Figure 1A illustrates a cross-section of a 3D FRAM memory according to a first embodiment. The 3D FRAM memory 100 includes a 3D array of ferroelectric capacitors 102 arranged in a plurality of vertical stacks 104 or columns, where each stack 104 of ferroelectric capacitors 102 is coupled to a single access transistor 106 at the base of the stack 104. Figure 1B illustrates a top view of the 3D FRAM memory, and Figure 1C illustrates a cross-section of the 3D FRAM memory along cross-section line A.

Referring to Figures 1A, 1B, and 1C, the 3D FRAM memory 100 includes a base level having a plurality of substantially parallel (e.g., within +-5 degrees) bitlines 108 along a first direction (in and out of the page in this view). Each of the bitlines 108 forms the basis of each of the stack 104 in the array. On a base +1 level, the 3D array includes a plurality of substantially parallel wordlines 110 along a second direction orthogonal (e.g., within +-5 degrees) to the first direction. Each respective access transistor 106 is located at the intersection of a respective bitline 108 and a respective wordline 110 and is coupled to the respective bitline 108 and wordline 110.

According to the disclosed embodiments, each stack 104 in the 3D array includes a first ferroelectric capacitor 102 vertically aligned with and coupled to the access transistor 106 and at least a second ferroelectric capacitor 102 vertically aligned with the first of ferroelectric capacitor 102 and also coupled to the access transistor 106, wherein both the first ferroelectric capacitor 102 and the second ferroelectric capacitor 102 are controlled by the access transistor 106. In the example shown, each stack 104 in the 3D array includes four vertically stacked ferroelectric capacitors 102. In one embodiment, each access transistor 106 may be coupled to 2-8 ferroelectric capacitors 102. This is in contrast to conventional arrays in which only one ferroelectric capacitor is coupled to an access transistor.

In additional detail, a channel region 112 of the transistor 106 is over and aligned with each bitline 108 and a gate dielectric 114 is along sides of the channel region 112. In one embodiment, the channel region 112 has substantially a same lateral dimension as the bitline 108, and the gate length is measured in the vertical direction.

Over the channel region 112 and the access transistor 106 is a stack of alternating plate lines 116 (e.g., PL1, PL2, PL3, PL4) and an insulating material 118 (e.g., an interlayer dielectric (ILD)) that are substantially parallel to the wordlines 110. In one embodiment, the number of plate lines 116 equals the number of ferroelectric capacitors 102 in the stack 104. Accordingly, in the example shown, there are four ferroelectric capacitors 102, and four plate lines 116 separated by four layers of insulating material 118.

In one embodiment, a node 120 of each of the capacitors 106 is formed and located in a hole 122 through the stack of alternating plate lines 116 and the insulating material 118 in alignment with the corresponding channel region 112 and the access transistor 106. The node 120 is one of the terminals of each of the ferroelectric capacitors 102 and is connected to, or includes, a source of the access transistor 106. Thus, the node 120 and the source of the access transistor 106 are basically the same electrical point. The node 120 is surrounded by a ferroelectric (or antiferroelectric) material 124 that is conformal to sidewalls of the hole 122. The ferroelectric material 124 stores the memory state for a bit cell as a form of polarization, which can be switched by an electric field. The node 120 is further connected to one plate line 116 of each of the ferroelectric capacitors 102 in the stack 104. Each of the plate lines 116 acts as a first electrode and the node 120 acts as a second electrode for the corresponding ferroelectric capacitor 102 in the stack 104. In this embodiment, the bitline 108 is the drain of the access transistor 106.

As described previously, the number of plate lines 116 may range from 2-8 using existing ferroelectric materials in the hole 122. The hole 122 may be approximately 40-200 nm in diameter/width, and in some embodiments up to 150 nm. The plate lines 116 may be up to approximately 100-350 nm in thickness, while the insulating material 118 may be up to approximately 50 nm in thickness. In one embodiment, the nodes 120 in each stack 104 may be up to approximately a maximum 2.8 microns in height (350 nm times x 8 plate lines). The node 120 and the channel region 112 are aligned and have the same width, which provides the best area for a memory cell.

Each ferroelectric capacitor 102 and plate line 116 combination forms one of the bit cells that are vertically stacked over the access transistor 106. The dimensional requirements of the bit cells are determined primarily by the ferroelectric capacitor 102 or the wordline pitch and bitline pitch. No additional horizontal area is required for the access transistor 106 as the channel region 112 of the access transistor 106 is aligned with and located directly above the bitline 108 with the ferroelectric capacitors 102 stacked directly over the access transistor 106. The disclosed embodiment provide a 3D FRAM memory 100 having vertical geometry that provides benefits of 5-10× area/bit and cost/bit scaling. In one embodiment, the 3D FRAM memory 100 may have a bit cell area of *4F²*/*n,* where *n* ≈ 8.

In some embodiments, the ferroelectric/antiferroelectric material 124 including the ferroelectric capacitor 102 may include, for example, materials exhibiting ferroelectric behavior at thin dimensions, such as hafnium zirconium oxide (HfZrO, also referred to as HZO, which includes hafnium, zirconium, and oxygen), silicon-doped (Si-doped) hafnium oxide (which is a material that includes hafnium, oxygen, and silicon), germanium-doped (Ge-doped) hafnium oxide (which is a material that includes hafnium, oxygen, and germanium), aluminum-doped (Al-doped) hafnium oxide (which is a material that includes hafnium, oxygen, and aluminum), yttrium-doped (Y- doped) hafnium oxide (which is a material that includes hafnium, oxygen, and yttrium), lead zirconate titanate (which is a material that includes lead, zirconium, and titanium), barium zirconate titanate (which is a material that includes barium, zirconium and titanium), and combinations thereof. Some embodiments include hafnium, zirconium, barium, titanium, and/or lead, and combinations thereof. In one embodiment, the ferroelectric material 124 may range from approximately 2 to 50 nm in thickness.

In some embodiments, the node 120 may include conductive material(s), e.g., metals, such as titanium, titanium nitride, or SrRuO₃ (SRO), as examples.

In some embodiments, one or more of the bitlines 108, the wordlines 110 and the plate lines 116 may include conductive material(s), e.g., metals, such as titanium, titanium nitride, tantalum nitride, platinum, copper, tungsten, tungsten nitride, and/or ruthenium, among other conductive materials and/or combinations thereof.

In one embodiment, insulating material 118 includes interlayer dielectric (ILD) layers. In one embodiment, the insulating material 118 is an oxide layer, e.g., a silicon oxide layer. In one embodiment, insulating material 118 is a low-k dielectric, e.g., silicon dioxide, silicon oxide, carbon doped oxide ("CDO"), or any combination thereof. In one embodiment,the insulating material 118 can include a nitride, oxide, a polymer, phosphosilicate glass, "fluorosilicate ("SiOF" (glass, organosilicate glass ("SiOCH or any combination thereof. In another embodiment, the insulating materials 118 can include a nitride layer, e.g., silicon nitride layer. In alternative embodiments, the insulating materials 118 can include an aluminum oxide, silicon oxide nitride, other oxide/nitride layer, any combination thereof, or other electrically insulating layer determined by an electronic device design.

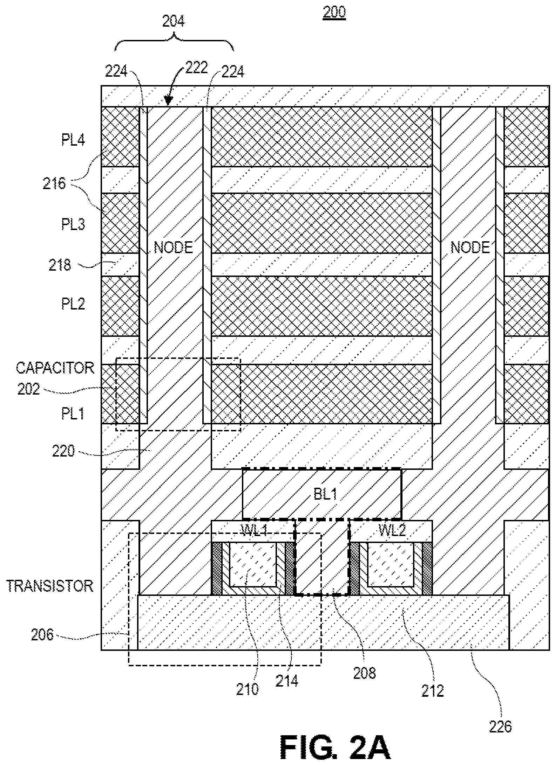

Figure 2A illustrates a cross-section of a 3D FRAM memory according to as a second embodiment. The 3D FRAM memory 200 includes a 3D array of ferroelectric capacitors 202 arranged in a plurality of vertical stacks 204 or columns. A single access transistor 206 at a base of each of the stacks 204 is coupled to the ferroelectric capacitors 202 in the stack 204. In this embodiment, the access transistor 206 includes a horizontally-oriented non-planar transistor, such as fin field effect transistor (FinFET) for instance.

In this cross-section, the base level includes a channel 212 of the access transistor 206 that is horizontal in this embodiment. Over the channel 212 is a plurality of substantially parallel wordlines 210 along a first direction (in and out of the page in this view). In between adjacent wordlines 210 is a bitline 208. The bitline 208 has a first portion along the first direction in between adjacent wordlines 210, and a second portion connected to the first portion that is outside the plane of the page and runs horizontally (i.e., along a second direction orthogonal to the first direction).

Each stack 204 in the 3D array includes a plurality of vertically aligned ferroelectric capacitors 202. The ferroelectric capacitors 202 are formed in a hole 222 through a series of alternating plate lines 216 (e.g., PL1, PL2, PL3, PL4) and an insulating material 218 (e.g., an interlayer dielectric (ILD)). The hole 222 is lined with a ferroelectric/antiferroelectric material 224 and filled with a conductive material forming a node 220. The node 220 extends down to a top of a substrate 226 and connects to the source of the access transistor 206 and corresponding wordline 210 (WL1). The wordline 210 acts a gate of the access transistor 206, and the bitline 208 acts as a drain of the access transistor 206. A gate dielectric 214 is along the sides and bottom of the wordline 210. Adjacent access transistors 206 share a common bitline 208.

As shown, the access transistor 206 is laid out horizontally and thus occupies a greater horizontal footprint than the embodiment of Figures 1A-1C, but may have manufacturing advantages. Similar to Figure 2A, however, because a ferroelectric material is used, a plurality of ferroelectric capacitors 202 can be vertically arranged to form a stack 204 and connected together using a single hole 222.

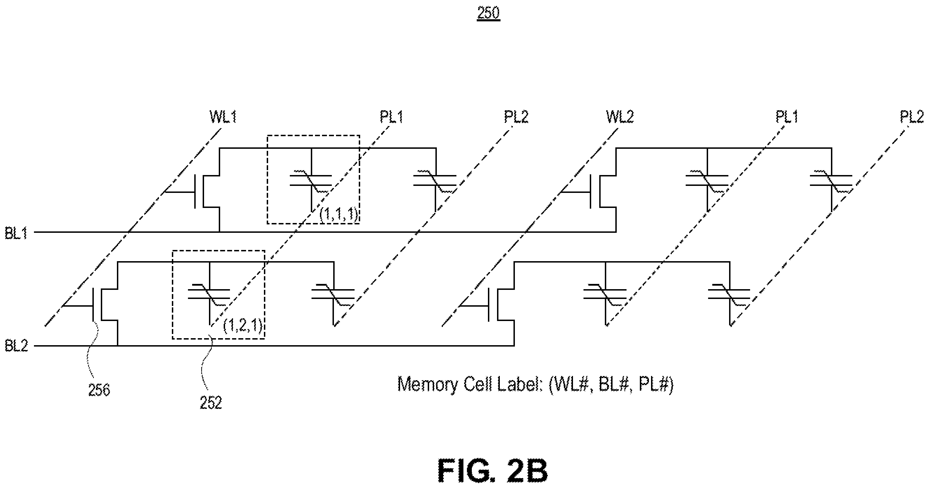

Figure 2B illustrates a circuit diagram showing a portion of a 3D FRAM memory array 250. In this example, a 2x2 WL and BL array is shown. There are 2 ferroelectric capacitors 252 in a stack including plate lines (e.g., PL1 and PL2) and connected to a single access transistor 256. Each row of plate lines (e.g., PL1 and PL2) may be referred to as a tier and a two plate line tier example is shown. There can be more than two plate lines and ferroelectric capacitors 252 per access transistor 256 in a stack, however. Bitlines (e.g., BL1 and BL2) are also shown, each coupled to a source of the access transistors 256 in the same stack. Rows of wordlines (e.g., WL1 and WL2) are shown, each coupled to a second terminal of the access transistors 256.

Some of the access transistors 256 in a column share one of the bitlines, e.g., BL1, and the access transistors 256 in another column share another bitline, e.g., BL2. No two of the access transistors 256 share the same bitline and the same wordline. Every access transistor 256 can be uniquely represented by a bitline and wordline combination. For example, there is an access transistor 256 connected to bitline BL1 and wordline WL1 and there is only one such access transistor 256. Similarly, there is one access transistor 256 connected to bitline BL1 and wordline WL2 and so on. Thus, every bit cell, which is connected to a plate line can be labeled with three coordinates of a particular wordline number, a particular bitline number and a particular plate line number. In Figure 2B, two bit cells are shown with a memory cell label (1, 1, 1) corresponding to wordline WL1, bitline BL1, and plate line PL1; and memory cell label (1, 2, 1) corresponding to wordline WL1, bitline BL2 and plate line PL1.

In one embodiment, the access transistors 256 may be used for both read and write access to the ferroelectric capacitors 252. The challenge is to ensure the access transistors 256 are writing a one to one bit cell, while the other bit cell(s) are not disturbed, which is essentially a half select. In one embodiment, an erase voltage is distributed between the plate line and the bitline so that the ferroelectric capacitors 252 not being written to only see half of the write voltage. The present embodiment ensures from a materials or device standpoint that setting half the write or program voltage does not cause the ferroelectric capacitors 252 to flip a bit or otherwise be disturbed unintentionally.

In another aspect, various architectures for plate lines may be implemented for 3D-Ferroelectric Random Access Memory (3D-FRAM). Embodiments disclosed herein provide approaches for connecting the plate lines in a three-dimensional FRAM architecture. Embodiments me be implemented to provide improvement in bit-density. Embodiments can be implemented to enable high-density memory with ferroelectric materials.

It is to be appreciated that embodiments described herein can be implemented to connect multiple ferroelectric capacitors to an access device, thus providing multiple bits per access device. According to embodiments, architectures for plate line (PL) connection for such a device are described. The physical structure of such plate line embodiments can be detectable from a cross-sectional transmission electron microscope (TEM) image. Cuts in the plate lines and the direction in which they run with respect to the wordlines can be used to identify a particular embodiment. The below described PL architectures each have associated advantages and possible drawbacks, and a particular embodiment can be chosen to balance out cost, energy/bit and area for a particular application.

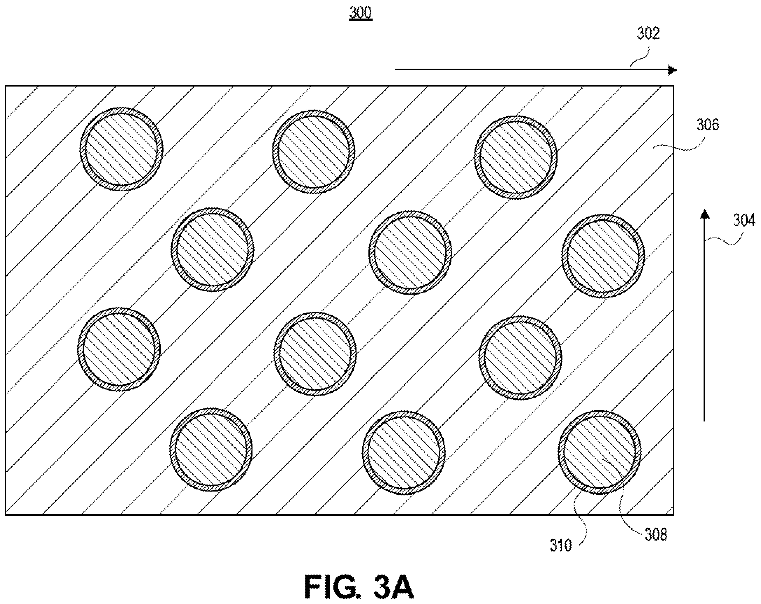

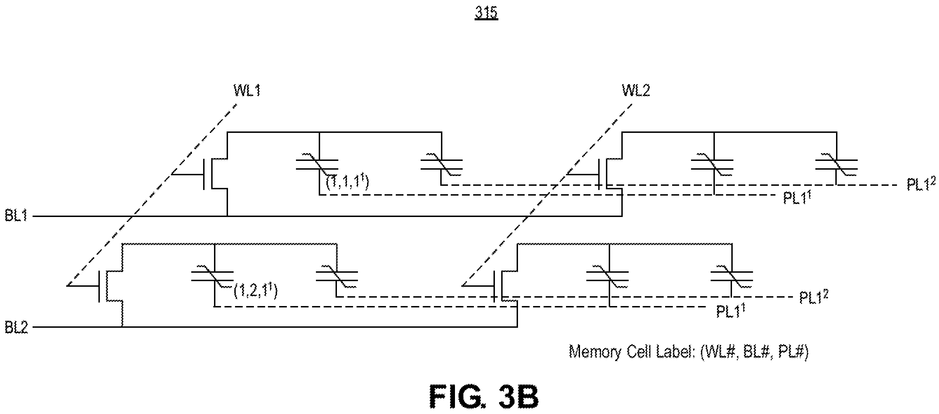

A first plate line (PL) architecture involves implementation of a single plate per tier. Such an architecture may exhibit facile integration, lower driver count, higher energy/bit, and/or higher current requirement on a PL driver. As an example, Figure 3A illustrates a top down view of a single tier 300 of a plate line having a single plate per tier, in accordance with an embodiment of the present disclosure. Figure 3B is a schematic 315 showing a memory having a plate line architecture of the type of Figure 3A, in accordance with an embodiment of the present disclosure. Referring to Figures 3A and 3B, a bitline (BL) direction (302) and a wordline (WL) direction (304) are shown. The PL architecture for a plate line (PL) of a single tier is based on a single plate 306. Nodes 308 surrounded by ferroelectric (or antiferroelectric) material 310 are surrounded laterally by the single plate 306.

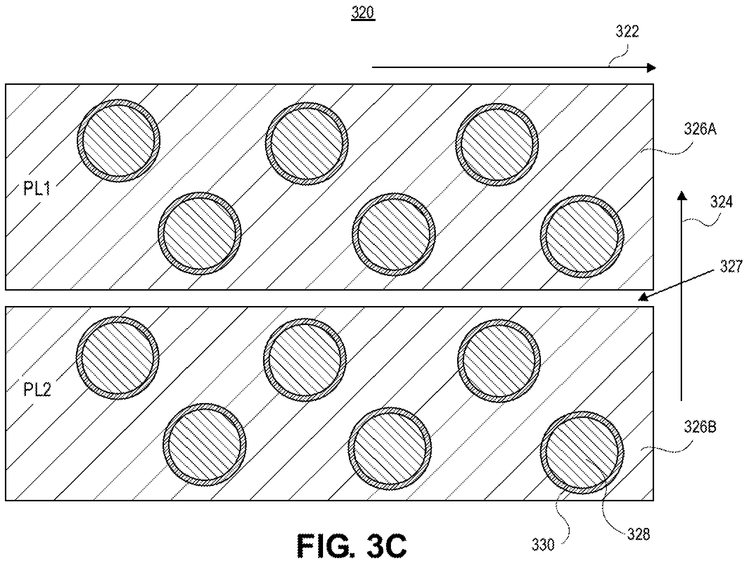

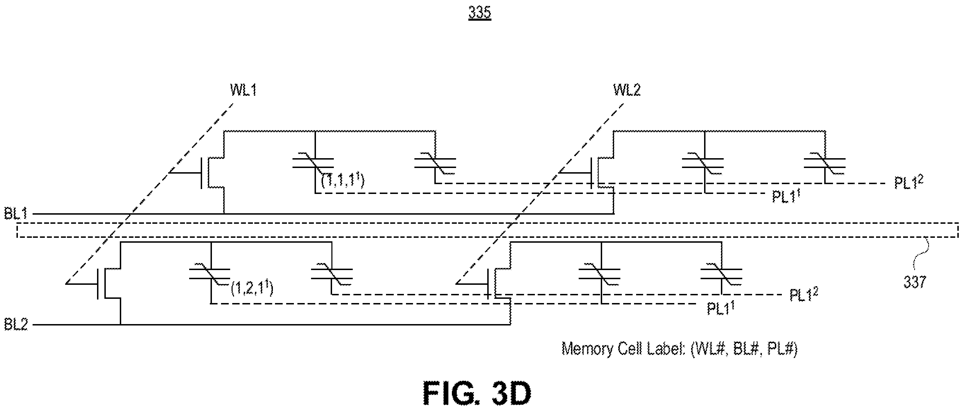

A second plate line (PL) architecture involves implementation of multiple plates per tier which are parallel with the bitlines. Such an architecture may exhibit more difficult integration, larger driver count, lower energy/bit, and/or lower current requirement on a PL driver. As an example, Figure 3C illustrates a top down view of a single tier 320 of a plate line having a multiple plates per tier oriented along a bitline direction, in accordance with an embodiment of the present disclosure. Figure 3D is a schematic 335 showing a memory having a plate line architecture of the type of Figure 3C, in accordance with an embodiment of the present disclosure. Referring to Figures 3C and 3D, a bitline (BL) direction (322) and a wordline (WL) direction (324) are shown. The PL architecture for a plate line (PL) of a single tier is based on multiple plates 326A/326B, or PL1/PL2. Nodes 328 surrounded by ferroelectric (or antiferroelectric) material 330 are surrounded laterally by the multiple plates 326A/326B. A plate line cut 327 or 337 is along the bitline (BL) direction 322 to provide the multiple plates 326A/326B each having a longest dimension parallel with BL direction 322.

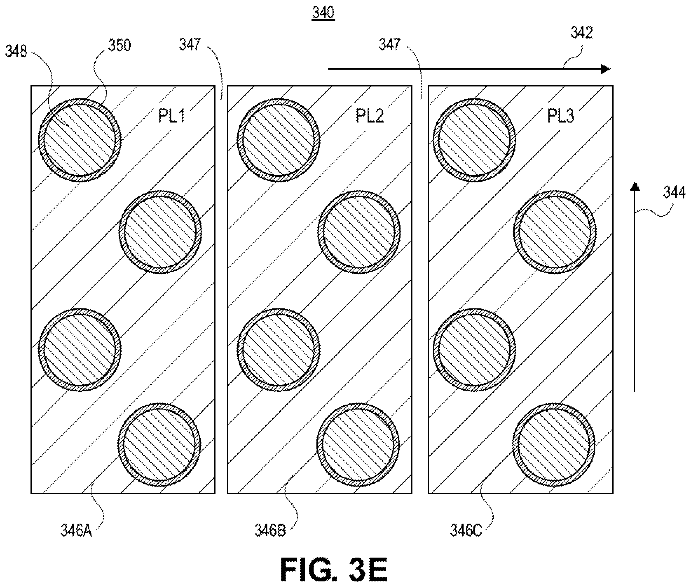

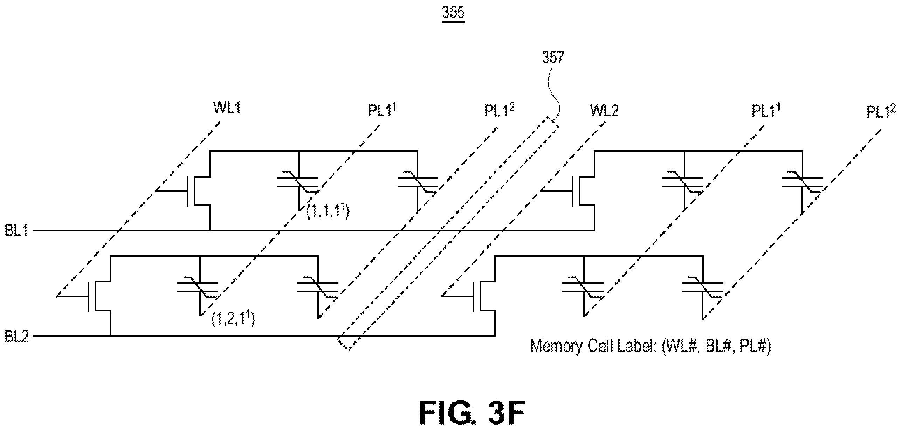

A third plate line (PL) architecture involves implementation of multiple plates per tier which are parallel with the wordlines. Such an architecture may exhibit medium difficulty integration, medium driver count, lower energy/bit, and/or medium current requirement on a PL driver. As an example, Figure 3E illustrates a top down view of a single tier 340 of a plate line having a multiple plates per tier oriented along a wordline direction, in accordance with an embodiment of the present disclosure. Figure 3F is a schematic 355 showing a memory having a plate line architecture of the type of Figure 3E, in accordance with an embodiment of the present disclosure. Referring to Figures 3E and 3F, a bitline (BL) direction (342) and a wordline (WL) direction (344) are shown. The PL architecture for a plate line (PL) of a single tier is based on multiple plates 346A/346B/346C, or PL1/PL2/PL3. Nodes 348 surrounded by ferroelectric (or antiferroelectric) material 350 are surrounded laterally by the multiple plates 346A/346B/346C. Plate line cuts 347 or 357 are along the wordline (WL) direction 344 to provide the multiple plates 346A/346B/346C each having a longest dimension parallel with WL direction 344.

In another aspect, bit cells are written to in a wordline wise manner such that all the bit cells are written along a corresponding wordline. In this case, because there are multiple plate lines in a stack of bit cells, the bit cells corresponding to a particular wordline and a particular plate line are written to.

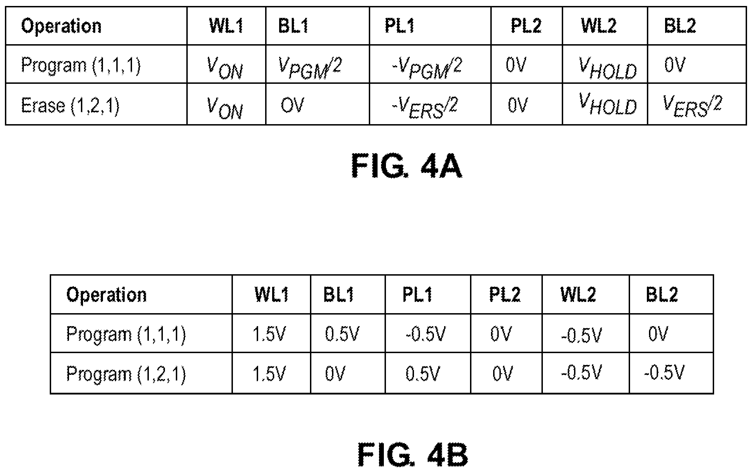

Figure 4A illustrates one possible operations table showing programming of bit cells along wordline WL1 and plate line PL1. In this example, a value of 1 is being written to bit cell (1, 1, 1) through a particular combination of voltages applied to wordline WL1, bitline BL1 and plate line PL1. In this example, WL1 = Vₒₙ, BL1 = V_{program}/2 and PL1 = -V_{program}/2. And at the same time, since plate line PL1 is also shared with bit cell (1, 2, 1) on the same wordline WL1, during the programing of bit cell (1, 1, 1), the voltage applied to bitline BL2 = 0V. Therefore, the voltage across bit cell (1, 2, 1), will be half of the read voltage (-Vₑᵣₐₛₑ/2), which shouldn't disturb the state of that bit cell. Also shown is an example of an erase of bit cell (1, 2, 1) that essentially flips the applied voltages so plate line PL1 would be taken to a positive voltage and BL2 would be taken to a negative voltage, which is the convention. In the embodiment shown, the voltage across bit cells that are not being written is 50% of the program voltage applied to bit cells being written to along the same plate line. However, in other embodiments, the voltage across bit cells that are not being written can be up to 75% of the program voltage applied to bit cells being written to along the same plate line.

Figure 4B illustrates one possible operation table with example values for the voltages applied to program and erase a bit cell. In embodiments, the voltage across bit cells that are not being written is up to 50% of the program voltage applied to bit cells being written to along the same plate line. During a program/write operation of bit cell (1, 1, 1), the On voltage applied to WL1 = 1.5V, the program voltage applied to BL1 is 0.5V, the program voltage applied to PL1 = -0.5V, the voltage applied to PL2 = 0V, the hold voltage applied to WL2 = -0.5V, and the voltage applied to BL2 = 0V. During an erase/write operation of bit cell (1, 2, 1), the voltage applied to WL1 = 1.5V, the voltage applied to BL1 is 0V, the erase voltage applied to PL1 = 0.5V, the voltage applied to PL2 = 0V, the hold voltage applied to WL2 = -0.5V, and the voltage applied to BL2 = -0.5V.

Generally, the process for fabricating the 3D FRAM array includes forming a bitline along a first direction. A wordline is formed along a second direction orthogonal to the first direction. An access transistor is formed coupled to the bitline and the wordline. A first ferroelectric capacitor is formed vertically aligned with and coupled to the access transistor. Finally, a second ferroelectric capacitor is formed vertically aligned with the first ferroelectric capacitor and coupled to the access transistor, wherein both the first ferroelectric capacitor and the second ferroelectric capacitor are controlled by the access transistor.

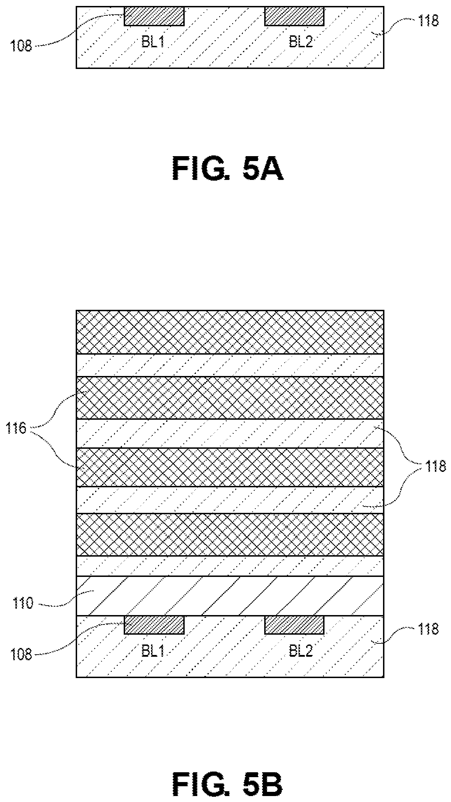

Figures 5A-5G illustrate cross-sectional views showing a process for fabricating a 3D FRAM in further detail, where like reference numerals from Figure 1 have like reference numerals. Figure 5A shows the process after a lithography step is used to form pattern a plurality of substantially parallel bitlines 108 along a first direction within the insulating material 118 over a substrate (not shown). In one embodiment, the insulating material 118 may include an oxide and the bitlines 108 may include a metal such as Cu.

Figure 5B shows the process after a plurality of substantially parallel wordlines 110 are formed over the bitlines 108 along a second direction orthogonal to the direction of the bitlines 108, and after a stack of alternating plate lines 116 and an insulating material 118 are deposited over the wordlines 110.

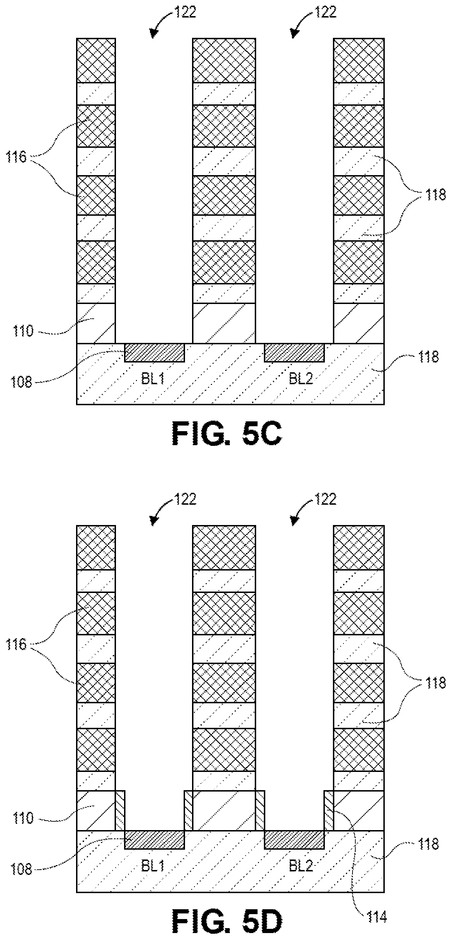

Figure 5C shows the process after holes 122 or trenches are etched through the stack of alternating plate lines 116 and an insulating material 118 and the wordlines 110.

Figure 5D shows the process after a gate dielectric 114 for the access transistors is deposited along sidewalls of the holes 122 in the wordlines 110. In one embodiment, the holes 122 is then mentioned such that after a gate dielectric 114 deposition, the gate dielectric 114 does not impinge on a top surface of the bitlines 108. The gate dielectric 114 is recessed down to be level with the top surface of the wordlines 110.

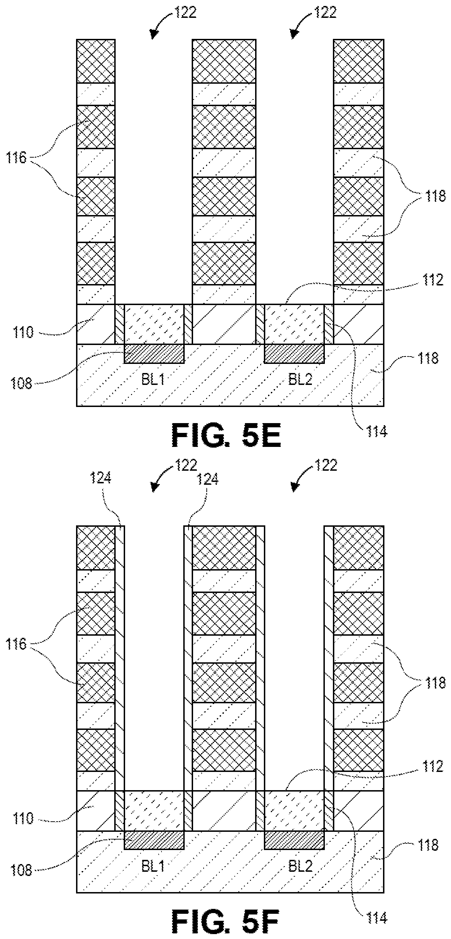

Figure 5E shows the process after a channel material 112 is deposited in the hole 122 over the bit lines 108 and recessed to a top surface of the wordlines 110.

Figure 5F shows the process after a ferroelectric (or antiferroelectric) material 124 is deposited conformal to sidewalls of the hole 122 and spacerized.

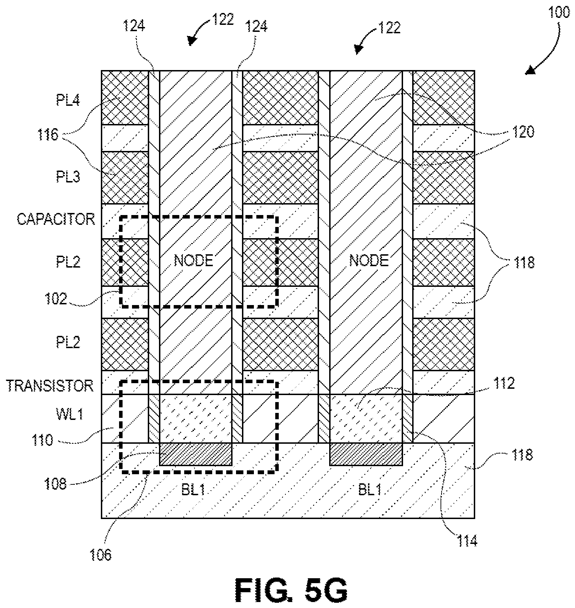

Figure 5G shows the process after a remainder of the hole 122 is filled with a metal and planarized to form nodes 120, completing formation of the 3D FRAM memory 100.

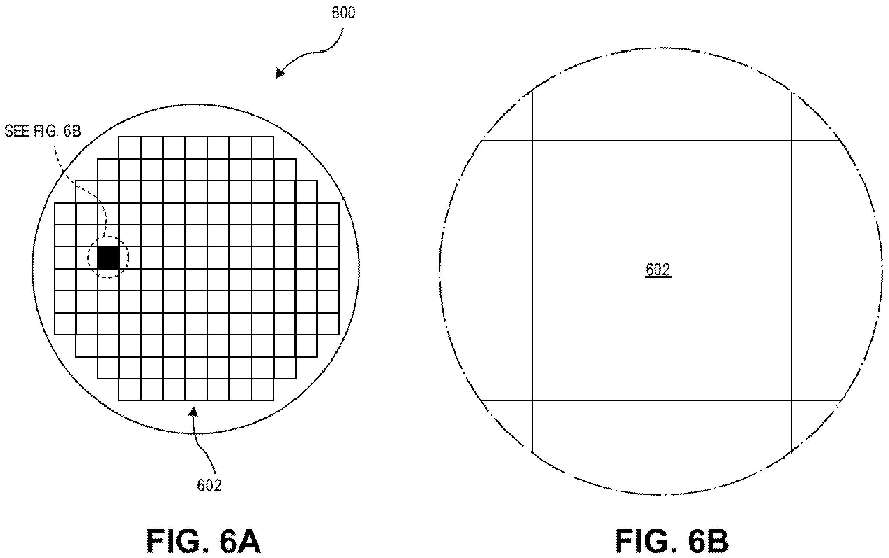

The integrated circuit structures described herein may be included in an electronic device. As an example of one such apparatus, Figures 6A and 6B are top views of a wafer and dies that include one or more ferroelectric trench capacitors, in accordance with one or more of the embodiments disclosed herein.

Referring to Figures 6A and 6B, a wafer 600 may be composed of semiconductor material and may include one or more dies 602 having integrated circuit (IC) structures formed on a surface of the wafer 600. Each of the dies 602 may be a repeating unit of a semiconductor product that includes any suitable IC (e.g., ICs including one or more ferroelectric trench capacitors, such as described above. After the fabrication of the semiconductor product is complete, the wafer 600 may undergo a singulation process in which each of the dies 602 is separated from one another to provide discrete "chips" of the semiconductor product. In particular, structures that include embedded non-volatile memory structures having an independently scaled selector as disclosed herein may take the form of the wafer 600 (e.g., not singulated) or the form of the die 602 (e.g., singulated). The die 602 may include one or more embedded non-volatile memory structures based independently scaled selectors and/or supporting circuitry to route electrical signals, as well as any other IC components. In some embodiments, the wafer 600 or the die 602 may include an additional memory device (e.g., a static random access memory (SRAM) device), a logic device (e.g., an AND, OR, NAND, or NOR gate), or any other suitable circuit element. Multiple ones of these devices may be combined on a single die 602. For example, a memory array formed by multiple memory devices may be formed on a same die 602 as a processing device or other logic that is configured to store information in the memory devices or execute instructions stored in the memory array.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

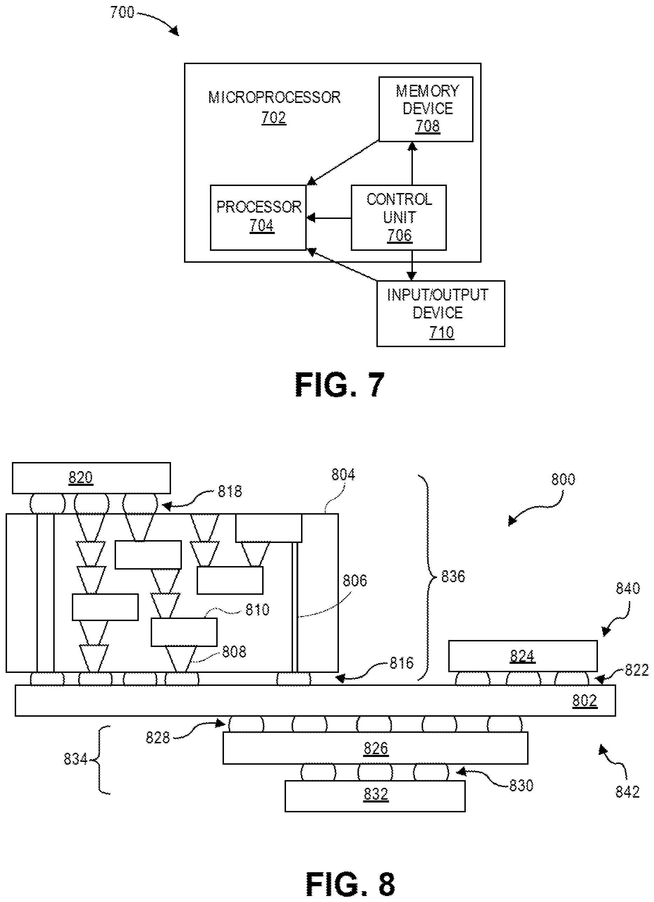

Figure 7 illustrates a block diagram of an electronic system 700, in accordance with an embodiment of the present disclosure. The electronic system 700 can correspond to, for example, a portable system, a computer system, a process control system, or any other system that utilizes a processor and an associated memory. The electronic system 700 may include a microprocessor 702 (having a processor 704 and control unit 706), a memory device 708, and an input/output device 710 (it is to be appreciated that the electronic system 700 may have a plurality of processors, control units, memory device units and/or input/output devices in various embodiments). In one embodiment, the electronic system 700 has a set of instructions that define operations which are to be performed on data by the processor 704, as well as, other transactions between the processor 704, the memory device 708, and the input/output device 710. The control unit 706 coordinates the operations of the processor 704, the memory device 708 and the input/output device 710 by cycling through a set of operations that cause instructions to be retrieved from the memory device 708 and executed. The memory device 708 can include a non-volatile memory cell as described in the present description. In an embodiment, the memory device 708 is embedded in the microprocessor 702, as depicted in Figure 7. In an embodiment, the processor 704, or another component of electronic system 700, includes one or more ferroelectric trench capacitors, such as those described herein.

Figure 8 is a cross-sectional side view of an integrated circuit (IC) device assembly that may include one or more ferroelectric trench capacitors, in accordance with one or more of the embodiments disclosed herein.

Referring to Figure 8, an IC device assembly 800 includes components having one or more integrated circuit structures described herein. The IC device assembly 800 includes a number of components disposed on a circuit board 802 (which may be, e.g., a motherboard). The IC device assembly 800 includes components disposed on a first face 840 of the circuit board 802 and an opposing second face 842 of the circuit board 802. Generally, components may be disposed on one or both faces 840 and 842. In particular, any suitable ones of the components of the IC device assembly 800 may include a number of ferroelectric trench capacitors, such as disclosed herein.

In some embodiments, the circuit board 802 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 802. In other embodiments, the circuit board 802 may be a non-PCB substrate.

The IC device assembly 800 illustrated in Figure 8 includes a package-on-interposer structure 836 coupled to the first face 840 of the circuit board 802 by coupling components 816. The coupling components 816 may electrically and mechanically couple the package-on-interposer structure 836 to the circuit board 802, and may include solder balls (as shown in Figure 8), male and female portions of a socket, an adhesive, an underfill material, and/or any other suitable electrical and/or mechanical coupling structure.

The package-on-interposer structure 836 may include an IC package 820 coupled to an interposer 804 by coupling components 818. The coupling components 818 may take any suitable form for the application, such as the forms discussed above with reference to the coupling components 816. Although a single IC package 820 is shown in Figure 8, multiple IC packages may be coupled to the interposer 804. It is to be appreciated that additional interposers may be coupled to the interposer 804. The interposer 804 may provide an intervening substrate used to bridge the circuit board 802 and the IC package 820. The IC package 820 may be or include, for example, a die (the die 602 of Figure 6B), or any other suitable component. Generally, the interposer 804 may spread a connection to a wider pitch or reroute a connection to a different connection. For example, the interposer 804 may couple the IC package 820 (e.g., a die) to a ball grid array (BGA) of the coupling components 816 for coupling to the circuit board 802. In the embodiment illustrated in Figure 8, the IC package 820 and the circuit board 802 are attached to opposing sides of the interposer 804. In other embodiments, the IC package 820 and the circuit board 802 may be attached to a same side of the interposer 804. In some embodiments, three or more components may be interconnected by way of the interposer 804.

The interposer 804 may be formed of an epoxy resin, a fiberglass-reinforced epoxy resin, a ceramic material, or a polymer material such as polyimide. In some implementations, the interposer 804 may be formed of alternate rigid or flexible materials that may include the same materials described above for use in a semiconductor substrate, such as silicon, germanium, and other group III-V and group IV materials. The interposer 804 may include metal interconnects 810 and vias 808, including but not limited to through-silicon vias (TSVs) 806. The interposer 804 may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 804. The package-on-interposer structure 836 may take the form of any of the package-on-interposer structures known in the art.

The IC device assembly 800 may include an IC package 824 coupled to the first face 840 of the circuit board 802 by coupling components 822. The coupling components 822 may take the form of any of the embodiments discussed above with reference to the coupling components 816, and the IC package 824 may take the form of any of the embodiments discussed above with reference to the IC package 820.

The IC device assembly 800 illustrated in Figure 8 includes a package-on-package structure 834 coupled to the second face 842 of the circuit board 802 by coupling components 828. The package-on-package structure 834 may include an IC package 826 and an IC package 832 coupled together by coupling components 830 such that the IC package 826 is disposed between the circuit board 802 and the IC package 832. The coupling components 828 and 830 may take the form of any of the embodiments of the coupling components 816 discussed above, and the IC packages 826 and 832 may take the form of any of the embodiments of the IC package 820 discussed above. The package-on-package structure 834 may be configured in accordance with any of the package-on-package structures known in the art.

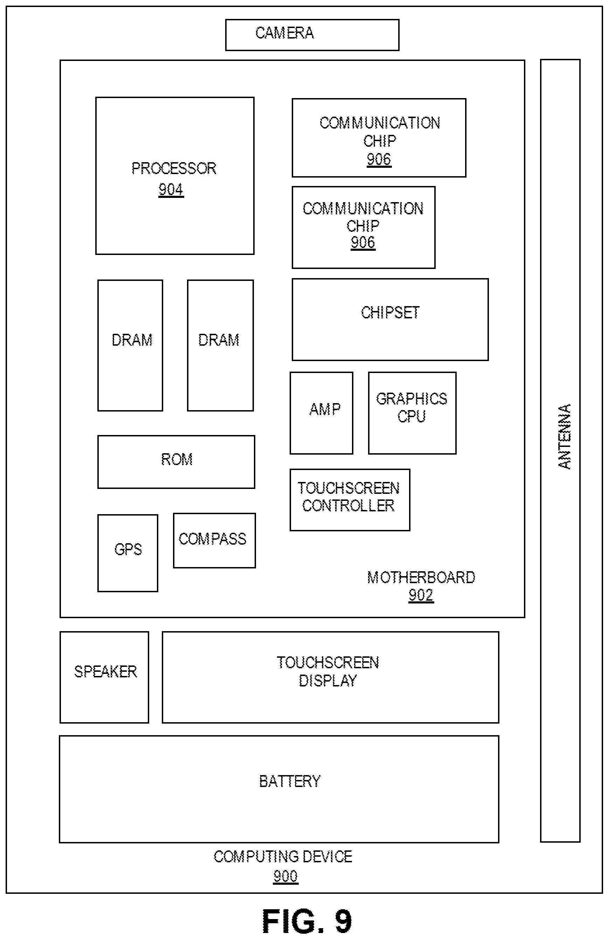

Figure 9 illustrates a computing device 900 in accordance with one implementation of the disclosure. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

Depending on its applications, computing device 900 may include other components that may or may not be physically and electrically coupled to the board 902. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the disclosure, the integrated circuit die of the processor includes one or more ferroelectric trench capacitors, in accordance with implementations of embodiments of the disclosure. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of embodiments of the disclosure, the integrated circuit die of the communication chip includes one or more ferroelectric trench capacitors, in accordance with implementations of embodiments of the disclosure.

In further implementations, another component housed within the computing device 900 may contain an integrated circuit die that includes one or more ferroelectric trench capacitors, in accordance with implementations of embodiments of the disclosure.

In various implementations, the computing device 900 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 900 may be any other electronic device that processes data.

Thus, plate line architectures for 3D-Ferroelectric Random Access Memory (3D-FRAM) are described.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example embodiment 1: A memory device includes a plurality of bitlines along a first direction and a plurality of wordlines along a second direction orthogonal to the first direction. An access transistor is at an intersection of a first one of the bitlines and a first one of the wordlines. A series of alternating plate lines and an insulating material is substantially parallel to the wordlines over the access transistor. Each of the plate lines includes a single plate. Two or more ferroelectric capacitors are over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor.

Example embodiment 2: The memory device of embodiment 1, wherein each of the two or more ferroelectric capacitors include a bit cell, and wherein a voltage across bit cells that are not being written is up to 75% of a voltage applied to the bit cells being written to along a same plate line.

Example embodiment 3: The memory device of embodiment 1 or 2, wherein the two or more ferroelectric capacitors are formed in a hole through the series of alternating plate lines and an insulating material, and wherein the hole is lined with a ferroelectric or antiferroelectric material and filled with a conductive material to form a node.

Example embodiment 4: The memory device of embodiment 3, wherein the hole is approximately 40-200 nm in diameter.

Example embodiment 5: The memory device of embodiment 3, wherein the hole is approximately 150 nm in diameter.

Example embodiment 6: The memory device of embodiment 1, 2, 3, 4 or 5, wherein the plate lines are up to approximately 350 nm in thickness, and the insulating material are up to approximately 50 nm in thickness.

Example embodiment 7: The memory device of embodiment 1, 2, 3, 4, 5 or 6, wherein the ferroelectric material includes any combination of one or more of: hafnium, zirconium, and oxygen; hafnium, oxygen, and silicon; hafnium, oxygen, and germanium; hafnium, oxygen, and aluminum; hafnium, oxygen, and yttrium; lead, zirconium, and titanium; barium, zirconium and titanium; hafnium, zirconium, barium, and titanium; and hafnium, zirconium, barium, and lead.

Example embodiment 8: A memory device includes a plurality of bitlines along a first direction and a plurality of wordlines along a second direction orthogonal to the first direction. An access transistor is at an intersection of a first one of the bitlines and a first one of the wordlines. A series of alternating plate lines and an insulating material is substantially parallel to the wordlines over the access transistor. Each of the plate lines includes a plurality of plates, where each of the plates has a longest dimension along the first direction. Two or more ferroelectric capacitors are over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor.

Example embodiment 9: The memory device of embodiment 8, wherein each of the two or more ferroelectric capacitors include a bit cell, and wherein a voltage across bit cells that are not being written is up to 75% of a voltage applied to the bit cells being written to along a same plate line.

Example embodiment 10: The memory device of embodiment 8 or 9, wherein the two or more ferroelectric capacitors are formed in a hole through the series of alternating plate lines and an insulating material, and wherein the hole is lined with a ferroelectric or antiferroelectric material and filled with a conductive material to form a node.

Example embodiment 11: The memory device of embodiment 10, wherein the hole is approximately 40-200 nm in diameter.

Example embodiment 12: The memory device of embodiment 10, wherein the hole is approximately 150 nm in diameter.

Example embodiment 13: The memory device of embodiment 8, 9, 10, 11 or 12, wherein the plate lines are up to approximately 350 nm in thickness, and the insulating material are up to approximately 50 nm in thickness.

Example embodiment 14: The memory device of embodiment 8, 9, 10, 11, 12 or 13, wherein the ferroelectric material includes any combination of one or more of: hafnium, zirconium, and oxygen; hafnium, oxygen, and silicon; hafnium, oxygen, and germanium; hafnium, oxygen, and aluminum; hafnium, oxygen, and yttrium; lead, zirconium, and titanium; barium, zirconium and titanium; hafnium, zirconium, barium, and titanium; and hafnium, zirconium, barium, and lead.

Example embodiment 15: A memory device includes a plurality of bitlines along a first direction and a plurality of wordlines along a second direction orthogonal to the first direction. An access transistor is at an intersection of a first one of the bitlines and a first one of the wordlines. A series of alternating plate lines and an insulating material is substantially parallel to the wordlines over the access transistor. Each of the plate lines includes a plurality of plates, where each of the plates has a longest dimension along the second direction. Two or more ferroelectric capacitors are over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor.

Example embodiment 16: The memory device of embodiment 15, wherein each of the two or more ferroelectric capacitors include a bit cell, and wherein a voltage across bit cells that are not being written is up to 75% of a voltage applied to the bit cells being written to along a same plate line.

Example embodiment 17: The memory device of embodiment 15 or 16, wherein the two or more ferroelectric capacitors are formed in a hole through the series of alternating plate lines and an insulating material, and wherein the hole is lined with a ferroelectric or antiferroelectric material and filled with a conductive material to form a node.

Example embodiment 18: The memory device of embodiment 17, wherein the hole is approximately 40-200 nm in diameter.

Example embodiment 19: The memory device of embodiment 17, wherein the hole is approximately 150 nm in diameter.

Example embodiment 20: The memory device of embodiment 15, 16, 17, 18 or 19, wherein the plate lines are up to approximately 350 nm in thickness, and the insulating material are up to approximately 50 nm in thickness.

Example embodiment 21: The memory device of embodiment 15, 16, 17, 18, 19 or 20, wherein the ferroelectric material includes any combination of one or more of: hafnium, zirconium, and oxygen; hafnium, oxygen, and silicon; hafnium, oxygen, and germanium; hafnium, oxygen, and aluminum; hafnium, oxygen, and yttrium; lead, zirconium, and titanium; barium, zirconium and titanium; hafnium, zirconium, barium, and titanium; and hafnium, zirconium, barium, and lead.

## Claims

1. A memory device, comprising:
a plurality of bitlines along a first direction;
a plurality of wordlines along a second direction orthogonal to the first direction;
an access transistor at an intersection of a first one of the bitlines and a first one of the wordlines;
a series of alternating plate lines and an insulating material over the access transistor, wherein each of the plate lines comprises a single plate; and
two or more ferroelectric capacitors over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor.

2. The memory device of claim 1, wherein each of the two or more ferroelectric capacitors comprise a bit cell, and wherein a voltage across bit cells that are not being written is up to 75% of a voltage applied to the bit cells being written to along a same plate line.

3. The memory device of claim 1 or 2, wherein the two or more ferroelectric capacitors are formed in a hole through the series of alternating plate lines and an insulating material, and wherein the hole is lined with a ferroelectric or antiferroelectric material and filled with a conductive material to form a node.

4. The memory device of claim 3, wherein the hole is approximately 40-200 nm in diameter.

5. The memory device of claim 3, wherein the hole is approximately 150 nm in diameter.

6. The memory device of claim 1, 2, 3, 4 or 5, wherein the plate lines are up to approximately 350 nm in thickness, and the insulating material are up to approximately 50 nm in thickness.

7. The memory device of claim 1, 2, 3, 4, 5 or 6, wherein the ferroelectric material comprises any combination of one or more of: hafnium, zirconium, and oxygen; hafnium, oxygen, and silicon; hafnium, oxygen, and germanium; hafnium, oxygen, and aluminum; hafnium, oxygen, and yttrium; lead, zirconium, and titanium; barium, zirconium and titanium; hafnium, zirconium, barium, and titanium; and hafnium, zirconium, barium, and lead.

8. A method of fabricating a memory device, the method comprising:
forming a plurality of bitlines along a first direction;
forming a plurality of wordlines along a second direction orthogonal to the first direction;
forming an access transistor at an intersection of a first one of the bitlines and a first one of the wordlines;
forming a series of alternating plate lines and an insulating material over the access transistor, wherein each of the plate lines comprises a single plate; and
forming two or more ferroelectric capacitors over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor.

9. The method of claim 8, wherein each of the two or more ferroelectric capacitors comprise a bit cell, and wherein a voltage across bit cells that are not being written is up to 75% of a voltage applied to the bit cells being written to along a same plate line.

10. The method of claim 8 or 9, wherein the two or more ferroelectric capacitors are formed in a hole through the series of alternating plate lines and an insulating material, and wherein the hole is lined with a ferroelectric or antiferroelectric material and filled with a conductive material to form a node.

11. The method of claim 10, wherein the hole is approximately 40-200 nm in diameter.

12. The method of claim 10, wherein the hole is approximately 150 nm in diameter.

13. The method of claim 8, 9, 10, 11 or 12, wherein the plate lines are up to approximately 350 nm in thickness, and the insulating material are up to approximately 50 nm in thickness.

14. The method of claim 8, 9, 10, 11, 12 or 13, wherein the ferroelectric material comprises any combination of one or more of: hafnium, zirconium, and oxygen; hafnium, oxygen, and silicon; hafnium, oxygen, and germanium; hafnium, oxygen, and aluminum; hafnium, oxygen, and yttrium; lead, zirconium, and titanium; barium, zirconium and titanium; hafnium, zirconium, barium, and titanium; and hafnium, zirconium, barium, and lead.
